**Europäisches Patentamt**

(19) **European Patent Office**

**Office européen des brevets**

(11) Numéro de publication: **0 242 291**
**B1**

(12) **FASCICULE DE BREVET EUROPEEN**

(45) Date de publication du fascicule du brevet:
**23.05.90**

(51) Int. Cl.⁵: **G11C 19/28, H01L 29/78**

(21) Numéro de dépôt: **87400845.1**

(22) Date de dépôt: **14.04.87**

(54) **Registre à décalage à transfert de charge muni d'un dispositif de lecture en tension sur diode flottante.**

(30) Priorité: **18.04.86 FR 8605647**

(43) Date de publication de la demande:
**21.10.87 Bulletin 87/43**

(45) Mention de la délivrance du brevet:
**23.05.90 Bulletin 90/21**

(84) Etats contractants désignés:
**DE GB NL**

(56) Documents cités:
**EP-A- 0 097 837**
**US-A- 3 906 359**
**US-A- 4 262 217**

**PATENT ABSTRACTS OF JAPAN,**
**vol. 2, no. 118, 30 septembre 1978, page 6811 E 78; &**
**JP-A-53 84 486 (MATSUSHITA DENKI SANGYO**
**K.K.) 25-07-1978**
**PATENT ABSTRACTS OF JAPAN,**
**vol. 2, no. 118, 30 septembre 1978, page 6811 E 78; &**
**JP-A-53 84 488 (MATSUSHITA DENKI SANGYO**
**K.K.) 25-07-1978**
**PATENT ABSTRACTS OF JAPAN,**
**vol. 3, no. 143, novembre 1979, page 24 E 154; &**
**JP-A-54 121 072 (NIPPON DENKI K.K.) 19-09-1979**

(73) Titulaire: **THOMSON-CSF, 51, Esplanade du Général de Gaulle, F-92800 Puteaux(FR)**

(72) Inventeur: **Boucharlat, Gilles, THOMSON-CSF SCPI 19, avenue de Messine, F-75008 Paris(FR)**

(74) Mandataire: **Turlèque, Clotilde et al, THOMSON-CSF SCPI, F-92045 PARIS LA DEFENSE CEDEX 67(FR)**

**Description**

La présente invention concerne un registre à décalage à transfert de charge muni d'un dispositif de lecture en tension sur diode flottante.

Il est bien connu dans le domaine du transfert de charge d'effectuer une lecture en tension sur une diode dont le potentiel est préchargé à une valeur de référence avant de recevoir la charge signal. Cette méthode de lecture des charges est décrite notamment dans l'article intitulé "Les dispositifs à transfert de charge", paru dans la Revue Technique THOMSON-CSF, volume 12, numéro 1, mars 1980, pages 41 à 45.

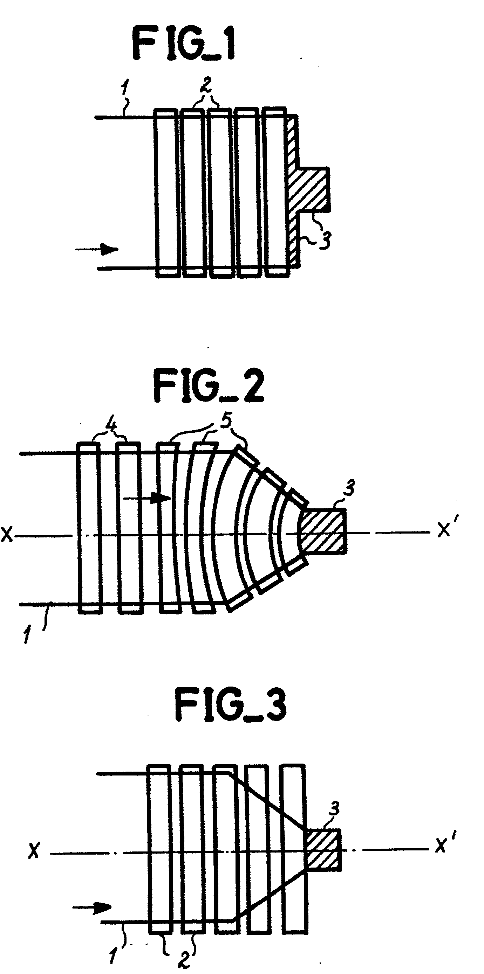

Sur la figure 1, on a représenté de façon schématique, un registre à décalage à transfert de charge vu de dessus. On a représenté les limites du canal de transfert des charges 1, de largeur constante, perpendiculairement au sens de transfert des charges, indiqué par une flèche horizontale. On a également représenté quelques électrodes 2 de forme rectangulaire qui sont identiques entre elles. Le registre à décalage se termine par une diode 3, destinée à collecter les charges issues du registre. Cette diode comporte une première partie occupant toute la largeur du canal, suivie par une deuxième partie, de plus faible largeur, sur laquelle est connectée l'entrée d'un amplificateur de sortie à haute impédance. Cette structure connue permet de réaliser une lecture en tension sur diode flottante.

La présente invention propose une structure nouvelle qui permet d'améliorer la lecture en tension sur diode flottante qui est réalisée. En particulier, la sensibilité et la linéarité se trouvent améliorées. L'inefficacité de transfert est réduite. On peut augmenter la fréquence de fonctionnement du registre à transfert de charge.

La présente invention concerne un registre à décalage à transfert de charge muni d'un dispositif de lecture en tension sur diode flottante, ledit registre comportant un canal de transfert des charges une partie du canal ayant une largeur constante, perpendiculairement au sens de transfert des charges, et des électrodes de dimension constante, selon le sens de transfert des charges et ladite diode étant connectée à une extrémité du registre où elle occupe toute la largeur du canal, caractérisé en ce que, vers l'extrémité du registre située du côté de la diode flottante, la largeur du canal diminue, de façon progressive,et les dernières électrodes ont une forme d'autant plus proche d'un secteur de couronne qu'elles sont proches de la diode flottante, de façon à rendre sensiblement uniforme pour chacune de ces électrodes, le trajet jusqu'à la diode flottante des charges qui la quittent, que les charges quittent l'électrode à proximité des bords du canal ou à proximité de l'axe longitudinal du registre.

D'autres objets, caractéristiques et résultats de l'invention ressortiront de la description suivante, donnée à titre d'exemple non limitatif et illustrée par les figures annexées qui représentent :

- la figure 1, une vue schématique d'un registre à décalage à transfert de charge muni d'un dispositif de lecture en tension sur diode flottante selon l'art antérieur ;
- la figure 2, une vue schématique d'un registre à décalage à transfert de charge muni d'un dispositif de lecture en tension sur diode flottante selon l'invention ;
- la figure 3, une vue schématique d'un registre à décalage à transfert de charge muni d'un dispositif de lecture en tension sur diode flottante, selon un mode de réalisation, proche de l'invention, mais qui ne donne pas satisfaction.

Sur les différentes figures, les mêmes repères désignent les mêmes éléments, mais, pour des raisons de clarté, les cotes et proportions des divers éléments ne sont pas respectées.

La figure 1 a été décrite dans l'introduction à la description.

La figure 2 représente, de façon schématique, une vue de dessus d'un registre à décalage à transfert de charge muni d'un dispositif de lecture en tension sur diode flottante selon l'invention.

On constate que la largeur du canal 1, c'est-à-dire sa dimension perpendiculairement au sens de transfert des charges indiqué par une flèche horizontale, est d'abord constante, puis que, vers l'extrémité du canal située du côté de la diode de lecture 3, la largeur du canal diminue de façon progressive, symétriquement par rapport à l'axe longitudinal XX' du registre.

La diode de lecture 3 occupe toute la largeur du canal de transfert des charges.

On constate sur la figure 2 que dans la partie du registre dont le canal a une largeur constante les électrodes sont des électrodes rectangulaires, identiques entre elles, comme le sont les deux électrodes 4 qui sont représentées. Puis, à proximité de l'endroit où la largeur du canal diminue, on a modifié la forme des électrodes. Les électrodes 5 du registre qui sont situées à proximité de la diode de lecture 3 ont une forme d'autant plus proche de celle d'un secteur de couronne qu'elles sont proches de la diode de lecture 3.

On sait que pour augmenter la sensibilité d'une lecture en tension réalisée sur une diode flottante placée en sortie d'un registre à décalage à transfert de charge, il faut réduire la capacité de la diode de lecture, et donc sa surface et son périmètre.

Par rapport à la structure selon l'art antérieur de la figure 1, la structure de la figure 2 présente une diode de lecture 3 de plus faible surface et de plus faible périmètre, et donc de plus faible capacité, ce qui améliore la sensibilité de la lecture réalisée.

On voit qu'on conserve au canal de transfert des charges la même largeur que dans le cas de la figure 1, excepté à proximité de la diode de lecture 3 où la largeur du canal diminue de façon progressive.

Si l'on conserve avec le canal de la figure 2 des électrodes 2, rectangulaires et identiques, tout le long du canal, les résultats obtenus ne sont pas satisfaisants. En effet, dans cette hypothèse qui est illustrée par la figure 3, pour les électrodes proches de la diode de lecture 3, la distance à parcourir pour atteindre la diode 3 est beaucoup plus longue pour les charges qui quittent une électrode donnée à proximité des bords du canal que pour les charges quittant la même électrode à proximité de l'axe XX'. Or, les calculs montrent que la durée du transfert d'un paquet de charges varie sensiblement comme le carré de la distance à parcourir. En conséquence, la structure de la figure 3 n'est pas satisfaisante car elle impose soit de fonctionner à des fréquences plus basses, que celles atteintes avec le dispositif de la figure 1, ce qui permet d'attendre l'arrivée des charges ayant à parcourir les plus grandes distances, soit d'admettre un fonctionnement avec une mauvaise linéarité.

La figure 2 montre comment les électrodes ont été modifiées pour supprimer l'inconvient du dispositif de la figure 3.

A proximité de la diode de lecture 3, on modifie la forme des électrodes de façon à rendre sensiblement uniforme le trajet jusqu'à la diode de lecture 3 des charges quittant chaque électrode, que ces charges quittent l'électrode à proximité des bords du canal ou à proximité de l'axe XX'.

Sur la figure 2, le mode de réalisation de l'invention représenté, comporte après des électrodes 4 rectangulaires et identiques, des électrodes dont la forme est intermédiaire entre le rectangle et le secteur de couronne et dont la forme se rapproche du secteur de couronne lorsqu'on se rapproche de la diode de lecture 3. La partie concave des électrodes est orientée vers la diode de lecture 3.

La dernière électrode du registre peut avoir exactement la forme d'un secteur de couronne.

Selon les caractéristiques que l'on cherche à obtenir pour le registre à décalage muni d'un dispositif de lecture en tension sur diode flottante, on détermine la façon dont le canal est modifié, le nombre d'électrodes qui ne sont pas rectangulaires, et la forme de ces électrodes.

En ce qui concerne les masques permettant d'obtenir les électrodes de forme non rectangulaire, on peut utiliser des moyens informatiques pour les obtenir.

Les électrodes dont la forme est modifiée n'ont pas néces sairement la même largeur sur l'axe XX'. Par contre, il est impératif que toutes les électrodes du registre aient une même surface active, c'est-à-dire une même capacité de stockage.

Ainsi, dans un exemple de réalisation, on a calculé les caractéristiques suivantes :
- largeur du canal avant rétrécissement : 40 μm ;
- largeur active du canal au niveau de la diode de lecture :18 μm ;
- distance de la diode de lecture à partir de laquelle la largeur du canal diminue : 30 μm ;
- largeur des électrodes rectangulaires, selon le sens du transfert :6,75 μm ;
- nombre d'électrodes de forme non rectangulaire : 3 ;
- dimensions de la diode de lecture ; cercle de 14 μm de diamètre, ce qui correspond à une surface de 155 μm² ;
- surface de la diode de lecture utilisée dans l'art antérieur avec un canal de largeur constante égal à 40 um : 270 μm².

Sur la figure 2, on constate que la diode de lecture 3 a une forme approximativement carrée avec le côté par lequel elle reçoit les charges provenant du registre sensiblement en arc de cercle, ce qui permet d'utiliser au mieux son périmètre. On peut utiliser une diode de forme circulaire, ce qui permet d'avoir le plus petit périmètre possible pour une surface donnée.

La structure proposée par l'invention permet d'obtenir une forte sensibilité et une meilleure efficacité de transfert au niveau des derniers étages du registre. Le temps d'arrivée des charges sur la diode de lecture est réduit et donc le signal vidéo est établi plus rapidement sur cette diode de lecture.

Il est possible d'augmenter la fréquence de fonctionnement du registre à transfert de charge et la diode de lecture a une réponse plus linéaire.

Dans le mode de réalisation de l'invention qui est représenté sur la figure 2, vers la fin du registre, la largeur du canal de transfert des charges 1 diminue, de façon progressive, et symétri quement par rapport à l'axe longitudinal XX' du registre. Il est bien entendu que cette dernière caractéristique n'est pas obligatoire et que l'invention couvre aussi des modes de réalisation dans lesquels la largeur du canal de transfert des charges 1 diminue, de façon progressive, mais non symétriquement par rapport à l'axe longitudinal XX' du registre.

**Revendications**

1. Registre à décalage à transfert de charge muni d'un dispositif de lecture en tension sur diode flottante (3), ledit registre comportant un canal (1) de transfert des charges, une partie du canal ayant une largeur constante, perpendiculairement au sens de transfert des charges, et des électrodes de dimension constante, selon le sens de transfert des charges et ladite diode (3) étant connectée à une extrémité du registre où elle occupe toute la largeur du canal, caractérisé en ce que, vers l'extrémité du registre située du côté de la diode flottante (3), la largeur du canal (1) diminue, de façon progressive et les dernières électrodes (5) ont une forme d'autant plus proche d'un secteur de couronne qu'elles sont proches de la diode flottante (3), de façon à rendre sensiblement uniforme pour chacune de ces électrodes (5), le trajet jusqu'à la diode flottante (3) des charges qui la quittent, que les charges quittent l'électrode à proximité des bords du canal ou à proximité de l'axe longitudinal (XX') du registre.

2. Registre selon la revendication 1, caractérisé en ce que, vers l'extrémité du registre située du côté de la diode flottante (3), la largeur du canal (1) diminue, de façon progressive et symétriquement par rapport à l'axe longitudinal (XX') du registre.

3. Registre selon l'une des revendications 1 ou 2, caractérisé en ce que la diode flottante (3) a une forme approximativement carrée, avec le côté par lequel arrivent les charges provenant du registre, sensiblement en arc de cercle.

4. Registre selon l'une des revendications 1 ou 2, caractérisé en ce que la diode flottante (3) a une forme circulaire.

## Patentansprüche

1. Ladungsüberführungs-Schieberegister, das mit einer Vorrichtung zum Auslesen über die Spannung an einer schwimmend angeordneten Diode (3) versehen ist, wobei dieses Register einen Ladungsüberführungskanal (1) umfaßt, ein Teil des Kanals eine konstante, zur Richtung der Ladungsüberführung senkrechte Breite sowie Elektroden mit konstanter Abmessung in Richtung der Ladungsüberführung aufweist, und wobei diese Diode (3) mit einem Ende des Registers hin, wo sie die ganze Breite des Kanals einnimmt, verbunden ist, dadurch gekennzeichnet, daß zu dem Ende des Registers, das auf der Seite der schwimmend angeordneten Diode (3) angeordnet ist, die Breite des Kanals (1) progressiv abnimmt und die letzten Elektroden (5) eine Form aufweisen, welche einem Kranzsektor um so näher ist, als sie der schwimmend angeordneten Diode (3) näher gelegen sind, so daß für jede dieser Elektroden (5) die Strecke der sie verlassenden Ladungen bis zur schwimmend angeordneten Diode (3) im wesentlichen gleich gemacht wird, und daß die Ladungen in der Nähe der Kanalränder oder in der Nähe der Längsachse (XX') des Registers die Elektorde verlassen.

2. Register nach Anspruch 1, dadurch gekennzeichnet, daß zu dem Ende des Registers hin, das auf der Seite der schwimmend angordneten Diode (3) gelegen ist, die Breite des Kanals progressiv und in bezug auf die Längsachse (XX') des Registers symmetrisch abnimmt.

3. Register nach Anspruch 1 oder 2, dadurch gekennzeichnet, daß die schwimmend angeordnete Diode (3) eine annähernd quadratische Form aufweist, wobei die Seite, durch welche die vom dem Register stammenden Ladungen ankommen, eine annähernd kreisbogenförmige Gestalt aufweist.

4. Register nach Anspruch 1 oder 2, dadurch gekennzeichnet, daß die schwimmend angeordnete Diode (3) kreisförmig ist.

## Claims

1. A charge transfer shift memory provided with a reading device using voltage acting on a floating diode (3), the said memory comprising a charge transfer channel (1), one part of said channel having a constant width, perpendicular to the direction of charge transfer, and electrodes with a constant dimension, in the direction of charge transfer, said diode (3) being connected to one end of the memory where it occupies the full width of the channel, characterized in that towards one end of the memory situated adjacent to the floating diode (3) there is a decrease in the width of the channel (1) in a progressive manner and the last electrodes (5) have a form which increasingly approaches the form of a sector of a ring in accordance with their proximity to the floating diode (3) in such a manner as to render substantially uniform, for each of these electrodes (5), the path as far as the floating diode (3) of the charges which leave it so that the charges leave the electrode in the proximity of the channel or in the proximity of the longitudinal axis (XX') of the memory.

2. The memory as claimed in claim 1, characterized in that towards the end of the memory situated adjacent to the floating diode (3) there is a decrease in the width of the channel (1) in a progressive manner and symmetrically with respect to the longitudinal axis (XX') of the memory.

3. The memory as claimed in claim 1 or in claim 2, characterized in that the floating diode (3) has an approximately square form so that the side at which the charges from the memory arrive is substantially in the form of a circular arc.

4. The memory as claimed in claim 1 or in claim 2, characterized in that the floating diode (3) has a circular form.

# FIG_1

# FIG_2

# FIG_3